# EUROPÄISCHE PATENTANMELDUNG

(11) **EP 0 602 268 A1**
(43) Veröffentlichungstag der Anmeldung: **22.06.1994**
(21) Anmeldenummer: 92121353.4
(22) Anmeldetag: 16.12.1992
(51) Int. Cl.: H01L 27/02, H01L 27/092

(54) **Integrierte Schaltung mit Feldeffekt-Transistoren**

(71) Anmelder: Landis & Gyr Business Support AG, CH-6301 Zug (CH)
(72) Erfinder: Pilloud, Bernard, CH-6312 Steinhausen (CH); Imfeld, Joe, CH-6048 Horw (CH); King, Martin Cranston, CH-6300 Zug (CH)

(57) **Zusammenfassung**

Ein Source-Anschluss (S) eines ersten Feldeffekt-Transistors (T_{N} von 11) liegt an einer ersten Speisespannung (V_{S}), während ein Anschluss (B) eines Bulk-Materials des gleichen Leitfähigkeitstyps (N) eines zweiten Feldeffekt-Transistors (T_{N} von 13) an einer unterschiedlichen zweiten Speisespannung (V_{SS}) liegt. Das Bulk-Material des zweiten Feldeffekt-Transistors (T_{N} von 13) besteht aus einer Halbleiterschicht, in der der erste Feldeffekt-Transistor (T_{N} von 11) unmittelbar eindiffundiert ist, so dass deren Halbleitermaterial auch das Bulk-Material des ersten Feldeffekt-Transistors (T_{N} von 11) bildet. Ein Bulk-Anschluss (B) des letzteren liegt zwecks gegenseitiger elektrischer Isolation der beiden Feldeffekt-Transistoren (T_{N} von 11, T_{N} von 13) an der zweiten Speisespannung (V_{SS}). Die integrierte Schaltung benötigt zur gegenseitigen Isolierung der Feldeffekt-Transistoren (T_{N} von 11, T_{N} von 13) keine zusätzliche Halbleiter-Wanne. Daher ist sie preisgünstiger, zuverlässiger sowie mit hoher Ausbeute und weniger Masken herstellbar.

## Beschreibung

Die Erfindung bezieht sich auf eine integrierte Schaltung mit Feldeffekt-Transistoren gemäss dem Oberbegriff des Anspruchs 1.

Die mindestens teilweise mittels Feldeffekt-Transistoren aufgebaute integrierte Schaltung wird in vorteilhafter Weise in elektronischen Schaltungen verwendet, die eine Mischung von Digital- und Analogschaltungen enthalten, welche von mehreren unterschiedlichen Speisespannungen gespeist sind, insbesonders wenn die Digitalschaltungen mindestens teilweise aus Speicherschaltungen, wie RAM, ROM, E²PROM, usw., bestehen. Die unterschiedlichen Speisespannungen sind dabei z. B. eine positive und eine negative Speisespannung, die beide auf ein gemeinsames Bezugspotential bezogen sind und mindestens drei elektrische Zuleitungen benötigen. Die Digital- und Analogschaltungen sind dabei aus Kostengründen vorzugsweise in einer einzigen, nämlich der eingangs genannten integrierten Schaltung integriert. Die erwähnten elektronischen Schaltungen sind z. B. Messgerät-Schaltungen, wie statische Elektrizitätszähler, welche je eine elektronische Anzeige, z. B. eine Flüssigkristall-Anzeige LCD ("liquid crystal display"), aufweisen zur Anzeige von Messwerten, die in sogenannten unverlierbaren Speichern ("non-volatile memories") gespeichert sind, welche ebenfalls in der einzig vorhandenen integrierten Schaltung integriert sind. Die dabei in der letzteren vorhandenen Feldeffekt-Transistoren sind von unterschiedlichem oder gleichem Kanaltyp N und/oder P und entweder unmittelbar oder über eine oder mehrere Halbleiter-Zwischenschichten in einer gemeinsamen Halbleiterschicht eindiffundiert, die z. B. ein Substrat oder eine auf einem Substrat aufgewachsene Epitaxieschicht ist. Die Halbleiter-Zwischenschichten haben oft die Gestalt einer Wanne und werden daher nachfolgend Halbleiter-Wannen genannt.

Jeder Feldeffekt-Transistor enthält bekanntlich zwei Diffusionen eines gleichen Leitfähigkeitstyps N bzw. P, die an der Oberfläche in einem gemeinsamen Halbleitermaterial eindiffundiert sind, welches nachfolgend als Bulk-Material B bezeichnet wird. In den erwähnten elektronischen Schaltungen liegt das Bulk-Material B vieler Feldeffekt-Transistoren gleichen Kanaltyps N oder P oft an unterschiedlichen elektrischen Potentialen, so dass alle diese Feldeffekt-Transistoren nicht unmittelbar, ohne geeignete Gegenmassnahmen, in eine gemeinsame Halbleiterschicht, wie z. B. ein Substrat oder eine Epitaxieschicht, eindiffundiert werden können, da die gemeinsame Halbleiterschicht die elektrischen Potentiale, an denen das Bulk-Material B der betreffenden Feldeffekt-Transistoren liegt, alle elektrisch kurzschliessen würde. Es ist jedoch, z. B. aus der CMOS-Technologie, bekannt, zur Vermeidung dieses elektrischen Kurzschlusses, die betreffenden Feldeffekt-Transistoren an der Oberfläche in je eine zugehörige Halbleiter-Wanne einzudiffundieren, welche ihrerseits an der Oberfläche in eine gemeinsame Halbleiterschicht des entgegengesetzten Leitfähigkeitstyps eindiffundiert sind und am gleichen elektrischen Potential liegen wie das Bulk-Material der in ihnen unmittelbar eindiffundierten Feldeffekt-Transistoren. Die P/N-Grenzschicht zwischen der betreffenden Halbleiter-Wanne und der gemeinsamen Halbleiterschicht ist dabei im Betrieb jeweils in Sperr-Richtung gepolt, so dass dort eine Sperrschicht entsteht, welche die betreffende Halbleiter-Wanne von der gemeinsamen Halbleiterschicht elektrisch isoliert, so dass kein elektrischer Kurzschluss durch die letztere mehr entstehen kann. Die Verwendung vieler Halbleiter-Wannen zur Vermeidung des Kurzschlusses vergeudet jedoch viel Platz, d. h. viel Chip-Fläche, reduziert die Ausbeute sowie die Zuverlässigkeit, erfordert zusätzliche Masken und ist daher relativ teuer.

Der Erfindung liegt die Aufgabe zugrunde, die bekannte Lösung so zu verbessern, dass eine preisgünstige integrierte Schaltung hoher Zuverlässigkeit entsteht, die mit hoher Ausbeute und weniger Masken herstellbar ist.

Die genannte Aufgabe wird erfindungsgemäss durch die im Kennzeichen des Anspruchs 1 angegebenen Merkmale gelöst. Eine vorteilhafte Ausgestaltung der Erfindung ergibt sich aus einem abhängigen Anspruch.

Die Erfindung hat weiterhin den Vorteil, dass die Mittel zur Lösung der Aufgabe auch zum Schreiben und Löschen von Speicherzellen vorhandener Speicher und/oder zum Setzen von Transistoren-Gruppen in bestimmte Betriebszustände verwendet werden können, was universeller einsetzbare Schaltungen ergibt und die Anzahl Kontroll-Zuleitungen reduziert, welche für die Programmierung und Löschung von Speicherzellen und/oder von Transistor-Betriebszuständen erforderlich sind. Ausserdem sind in mindestens einer Lösungs-Variante Anwendungen möglich, in denen eine spezielle Kontrolle der Kanal-Tiefe der vorhandenen Feldeffekt-Transistoren möglich ist.

Ausführungsbeispiele der Erfindung sind in der Zeichnung dargestellt und werden im folgenden näher beschrieben.

Es zeigen:
- Fig. 1: einen Querschnitt einer bekannten konventionellen, mittels Einzelwanne ("single well") hergestellten CMOS-Inverter-Halbleiteranordnung,
- Fig. 2: ein Schaltbild einer bekannten, mittels Doppelwanne ("twin well") hergestellten ersten Variante einer möglichen CMOS-Schaltung,
- Fig. 3: einen Querschnitt einer zur Fig. 2 gehörenden bekannten CMOS-Inverter-Halbleiteranordnung,
- Fig. 4: ein Schaltbild einer ersten Variante einer mittels Einzelwanne ("single well") hergestellten erfindungsgemässen möglichen CMOS-Schaltung,
- Fig. 5: einen Querschnitt einer zur Fig. 4 gehörenden ersten Variante einer erfindungsgemässen CMOS-Inverter-Halbleiteranordnung,
- Fig. 6: ein Schaltbild einer bekannten, mittels Doppelwanne ("twin well") hergestellten zweiten Variante der möglichen CMOS-Schaltung,
- Fig. 7: einen Querschnitt einer zur Fig. 6 gehörenden bekannten CMOS-Inverter-Halbleiteranordnung,
- Fig. 8: ein Schaltbild einer zweiten Variante der mittels Einzelwanne ("single well") hergestellten erfindungsgemässen möglichen CMOS-Schaltung,
- Fig. 9: einen Querschnitt einer zur Fig. 8 gehörenden zweiten Variante der erfindungsgemässen CMOS-Inverter-Halbleiteranordnung,
- Fig. 10: ein Schaltbild einer dritten Variante der mittels Einzelwanne ("single well") hergestellten erfindungsgemässen CMOS-Inverter-Halbleiteranordnung,
- Fig. 11: einen Querschnitt der zur Fig. 10 gehörenden dritten Variante der erfindungsgemässen CMOS-Inverter-Halbleiteranordnung,
- Fig. 12: einen Querschnitt einer Variante der in der Fig. 3 dargestellten bekannten, mittels Doppelwanne ("twin well") hergestellten CMOS-Inverter-Halbleiteranordnung und
- Fig. 13: ein Schaltbild der in der Fig. 12 dargestellten bekannten CMOS-Inverter-Halbleiteranordnung.

Gleiche Bezugszahlen bezeichnen in allen Figuren der Zeichnung gleiche Teile.

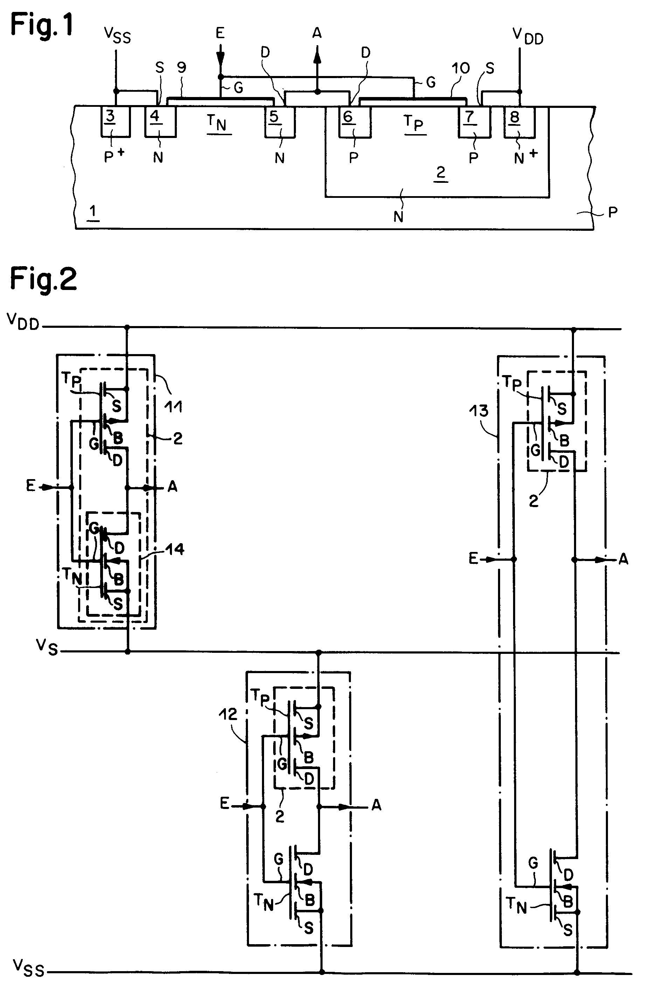

Nachfolgend gilt die Annahme, dass P ein erster und N ein zweiter Leitfähigkeitstyp eines jeweils verwendeten Halbleitermaterials ist. Weiter gilt die Annahme, dass eine positive und eine negative Speisespannung V_{DD} bzw. V_{SS} vorhanden sind, deren Bezugspotential V_{S} z. B. 0 Volt ist. Ausserdem werden vorhandene Feldeffekt-Transistoren nachfolgend einfachshalber als FET-Transistoren bezeichnet. In den Figuren 2, 4, 6, 8 und 10 ist das Vorhandensein einer Halbleiter-Wanne jeweils symbolisch durch eine gestrichelte Umrahmung des betreffenden FET-Transistors angedeutet.

Ein in der Fig. 1 dargestellter konventioneller, in CMOS-Technologie hergestellter Inverter besteht bekannterweise aus einer gemeinsamen Halbleiterschicht 1, in der an der Oberfläche eine Halbleiter-Wanne 2, eine erste Kontakt-Diffusion 3, eine erste Source-Diffusion 4 und eine erste Drain-Diffusion 5 eindiffundiert sind. Die gemeinsame Halbleiterschicht 1 ist vorzugsweise ein Substrat oder eine auf einem Substrat aufgewachsene Epitaxieschicht. In der Halbleiter-Wanne 2 sind an der Oberfläche eine zweite Drain-Diffusion 6, eine zweite Source-Diffusion 7 und eine zweite Kontakt-Diffusion 8 eindiffundiert. Das Halbleitermaterial der Halbleiterschicht 1 und der Diffusionen 3, 6 und 7 ist z. B. vom ersten Leitfähigkeitstyp P. Das Halbleitermaterial der Halbleiter-Wanne 2 und der Diffusionen 4, 5 und 8 ist dann vom entgegengesetzten, zweiten Leitfähigkeitstyp N. Die Leitfähigkeits-Bezeichnungen P und N des Halbleitermaterials der beiden Kontakt-Diffusionen 3 und 8 sind mit einem hochgestellten Index + versehen und somit als P⁺ bzw. N⁺ bezeichnet, da dieses Halbleitermaterial zwecks Realisierung je eines ohmschen Kontaktes stärker mit Fremdatomen dotiert als dasjenige der Halbleiterschicht 1 bzw. der Halbleiter-Wanne 2.

Ein erstes und zweites Gate 9 und 10 sind elektrisch isoliert auf der Oberfläche der Halbleiterschicht 1 bzw. der Halbleiter-Wanne 2 angeordnet. Das erste Gate 9 bedeckt teilweise die Oberfläche der beiden Diffusionen 4 und 5 sowie vollständig den zwischen den beiden letzteren vorhandenen Zwischenraum der Halbleiterschicht 1. Dieser Zwischenraum, das Gate 9 und die beiden Diffusionen 4 und 5 bilden zusammen einen FET-Transistor T_{N} des Kanaltyps N. Das zweite Gate 10 bedeckt teilweise die Oberfläche der beiden Diffusionen 6 und 7 sowie vollständig den zwischen den beiden letzteren vorhandenen Zwischenraum der Halbleiter-Wanne 2. Dieser Zwischenraum, das Gate 10 und die beiden Diffusionen 6 und 7 bilden zusammen einen FET-Transistor T_{P} des Kanaltyps P.

Die Speisespannungen V_{DD} und V_{SS} sowie elektrische Anschlüsse der Diffusionen 3 bis 8 und der Gates 9 und 10 sind mittels in der Regel externer, ausserhalb des Halbleitermaterials liegender elektrisch gut leitender Verbindungen teilweise miteinander verbunden. Die letzteren sind in der Zeichnung zwar jeweils als Drähte dargestellt, bestehen in der Praxis jedoch in der Regel aus sogenannten Metallisierungen, die auf der Oberfläche des Halbleitermaterials aufgedampft sind, oder aus hochleitendem Kunststoff, der auf oder an der Oberfläche des Halbleitermaterials angeordnet ist. Auf diese Art sind Gateanschlüsse G der beiden Gates 9 und 10 miteinander verbunden und bilden zusammen einen Eingang E des Inverters. Drain-Anschlüsse D der beiden Drain-Diffusionen 5 und 6 sind ebenfalls auf diese Art miteinander verbunden, so dass die beiden FET-Transistoren T_{N} und T_{P} elektrisch in Reihe geschaltet sind, wobei die beiden miteinander verbundenen Drain-Anschlüsse D zusammen einen Ausgang A des Inverters bilden. Die Halbleiter-Wanne 2 bildet das sogenannte Bulk-Material B des FET-Transistors T_{P} und liegt über die Kontakt-Diffusion 8 und eine zugehörige Metallisierung an die Speisespannung V_{DD}. Die Halbleiterschicht 1 bildet dagegen das Bulk-Material B des FET-Transistors T_{N} und liegt über die Kontakt-Diffusion 3 und eine zugehörige Metallisierung an die Speisespannung V_{SS}.

In dem in der Fig. 1 dargestellten Inverter sind die beiden Diffusionen 3 und 4 einerseits und die beiden Diffusionen 7 und 8 anderseits durch je eine Metallisierung elektrisch miteinander verbunden, so dass einerseits die Source-Diffusion 4 und das Bulk-Material B (d. h. die Halbleiterschicht 1) des FET-Transistors T_{N} beide an der negativen Speisespannung V_{SS} liegen sowie anderseits die Source-Diffusion 7 und das Bulk-Material B (d. h. die Halbleiter-Wanne 2) des FET-Transistors T_{P} beide an der positiven Speisespannung V_{DD} liegen.

Die in den Figuren 2, 4, 6 und 8 dargestellten elektronischen Schaltungen sind ähnlich aufgebaut und bestehen jeweils aus drei, in CMOS-Technologie hergestellten Invertern 11, 12 und 13, die unterschiedlich gespeist sind, jedoch alle drei halbleitermässig ähnlich aufgebaut sind wie der in der Fig. 1 dargestellte Inverter. Der Inverter 11 wird jeweils von den Speisespannungen V_{DD} und V_{S}, der Inverter 12 jeweils von den Speisespannungen V_{S} und V_{SS} und der Inverter 13 jeweils von den Speisespannungen V_{DD} und V_{SS} gespeist. Der Aufbau und die Speisung des Inverters 13 sind genau identisch mit dem Aufbau und der Speisung des in der Fig. 1 dargestellten Inverters.

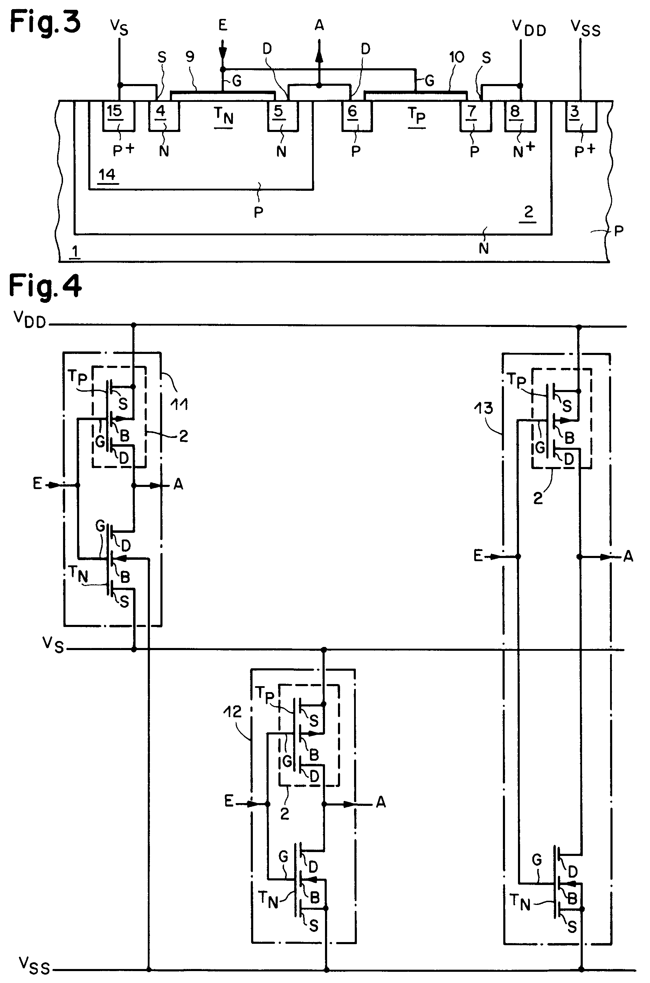

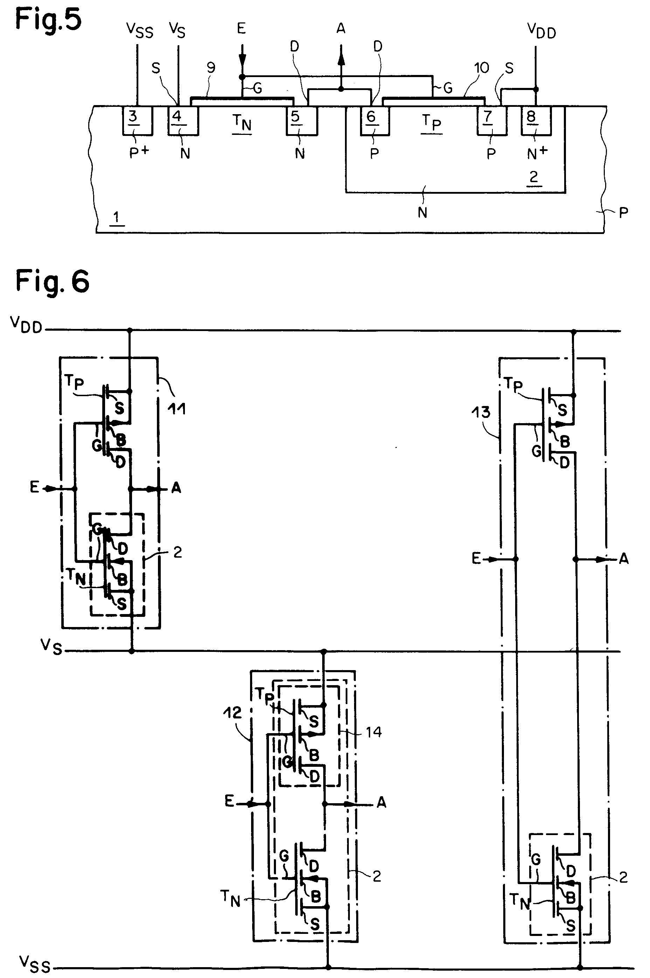

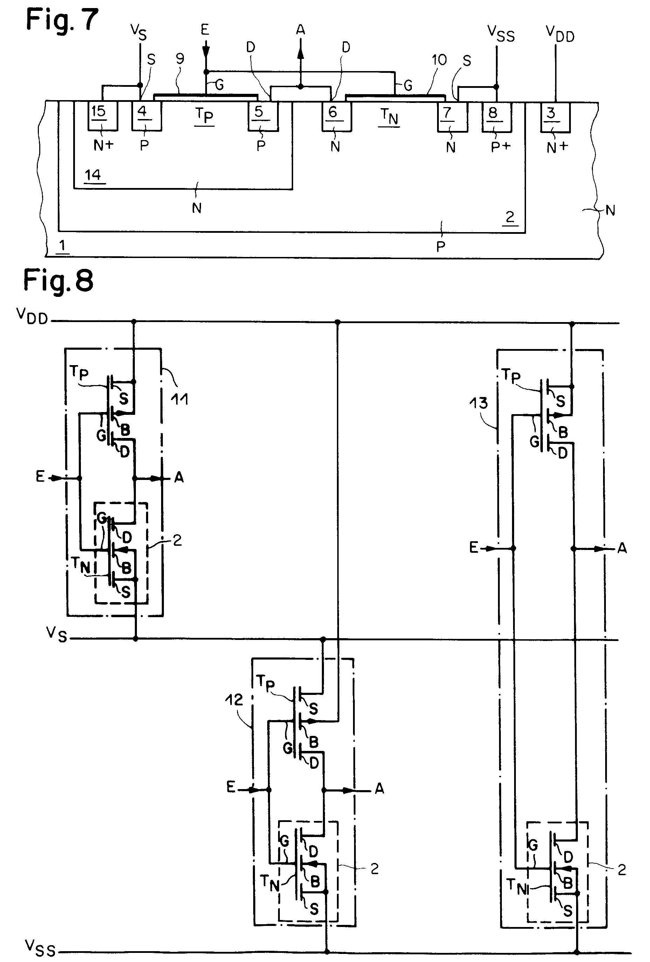

In der Fig. 2 und der Fig. 6 sind zwei bekannte konventionelle CMOS-Schaltungen dargestellt, in denen ein durch die Halbleiterschicht 1 erzeugter Kurzschluss durch das Vorhandensein einer zusätzlichen Halbleiter-Wanne 14 vermieden wird. Die Fig. 4 und Fig. 8 stellen ihrerseits jeweils eine erfindungsgemässe Lösung für die in der Fig. 2 bzw. Fig. 6 dargestellte CMOS-Schaltung dar.

In den bekannten konventionellen CMOS-Schaltungen sind in jedem FET-Transistor T_{N} und T_{P} dessen Bulk-Material B und dessen Source-Diffusion 4 bzw. 7 miteinander verbunden, so dass beide ein gleiches elektrisches Potential aufweisen. Dies hat zur Folge, dass das Bulk-Material B der FET-Transistoren T_{P} der Inverter 11 und 13 an der Speisespannung V_{DD}, dasjenige des FET-Transistors T_{N} des Inverters 11 und des FET-Transistors T_{P} des Inverters 12 an der Speisespannung V_{S} und dasjenige der FET-Transistoren T_{N} der Inverter 12 und 13 an der Speisespannung V_{SS} liegt (siehe Fig. 2 und Fig. 6). Liegt nun die Halbleiterschicht 1 an der niedrigsten in der integrierten Schaltung vorhandenen Speisespannung V_{SS}, was in den Figuren 1 bis 5 angenommen wird, so werden die elektrischen Speisespannungen V_{S} und V_{SS}, an denen das Bulk-Material B des FET-Transistors T_{N} des Inverters 11 bzw. die Halbleiterschicht 1 liegt, durch die letztere kurzgeschlossen.

Es ist bekannt, dass der erwähnte Kurzschluss vermieden werden kann, wenn der FET-Transistor T_{N} des Inverters 11 an der Oberfläche in der zusätzlichen Halbleiter-Wanne 14 angeordnet ist, was in der Fig. 2 symbolisch durch die gestrichelte Umrahmung 14 des betreffenden FET-Transistors T_{N} dargestellt ist. Der Inverter 11 besitzt dann den in der Fig. 3 dargestellten Aufbau, der ähnlich ist wie der in der Fig. 1 dargestellte Aufbau, mit dem Unterschied, dass die Halbleiter-Wanne 14, in der an der Oberfläche die Diffusionen 4 und 5 des FET-Transistors T_{N} eindiffundiert sind, selber in der Halbleiter-Wanne 2 eindiffundiert ist, wobei die Halbleiter-Wanne 14 aus Halbleitermaterial des ersten Leitfähigkeitstyps P besteht und eine zusätzliche Kontakt-Diffusion 15 aufweist, die in ihr an der Oberfläche eindiffundiert ist und aus Halbleitermaterial des ersten Leitfähigkeitstyps P besteht, welches um einen ohmschen Kontakt zu verwirklichen stärker mit Fremdatomen dotiert ist als die Halbleiter-Wanne 14 und daher mit P⁺ bezeichnet ist. Ausserdem sind die beiden Diffusionen 4 und 15 mittels z. B. einer Metallisierung miteinander und mit der Speisespanmnung V_{S} verbunden. Ansonsten ist der in der Fig. 3 dargestellte Aufbau gleich wie der in der Fig. 1 dargestellte Aufbau.

Die Grenzschichten zwischen den beiden Halbleiter-Wannen 14 und 2 einerseits und zwischen der Halbleiterwanne 2 und der Halbleiterschicht 1 anderseits sind beide in Sperr-Richtung gepolt, wodurch dort jeweils eine Sperrschicht als elektrische Isolationsschicht entsteht, so dass der FET-Transistor T_{N} im Betrieb durch zwei Sperrschichten von der Halbleiterschicht 1 isoliert ist und die Speisespannung V_{S} seines Bulk-Materials B, welches mit dem Halbleitermaterial der Halbleiter-Wanne 14 identisch ist, nicht mehr durch die Halbleiterschicht 1 mit der Speisespannung V_{SS} kurzgeschlossen wird.

Wie aus der Fig. 3 leicht ersichtlich ist, braucht die Halbleiter-Wanne 14 zusätzlichen Platz, d. h. zusätzliche Chip-Fläche, und zu ihrer Herstellung mindestens eine zusätzliche Maske. Die Ausbeute und Zuverlässigkeit der integrierten Schaltung wird dadurch reduziert und ihr Preis erhöht. Um dies zu vermeiden, verwendet eine in den Figuren 4 und 5 dargestellte erste Variante der erfindungsgemässen Lösung des Inverters 11 keine Halbleiter-Wanne 14 mehr. Die in der Fig. 4 dargestellte Schaltung ist ähnlich aufgebaut wie die in der Fig. 2 dargestellte Schaltung mit dem Unterschied, dass die Halbleiter-Wanne 14 nicht mehr vorhanden ist und der elektrische Anschluss des Bulk-Materials B des FET-Transistors T_{N} des Inverters 11 nicht mehr mit dessen Source-Anschluss S und damit mit der Speisespannung V_{S} verbunden ist, sondern mit der niedrigsten in der integrierten Schaltung vorhandenen Speisespannung V_{SS} verbunden ist. Da das Bulk-Material B des FET-Transistors T_{N} des Inverters 11 nun identisch ist mit der Halbleiterschicht 1, besitzt es das gleiche Potential V_{SS} wie diese. Der zugehörige FET-Transistor T_{N} des Inverters 11 ist genau wie die FET-Transistoren T_{N} der Inverter 12 und 13 unmittelbar in die Halbleiterschicht 1 eindiffundiert, ohne dass ein Kurzschluss entsteht, obwohl der Source-Anschluss S des betreffenden FET-Transistors T_{N} des Inverters 11 weiterhin an der Speisespannung V_{S} liegt. Der Aufbau des erfindungsgemäss so gespeisten Inverters 11 ist in der Fig. 5 dargestellt. Der in der Fig. 5 dargestellte Aufbau ist ähnlich wie der in der Fig. 1 dargestellte Aufbau, mit dem Unterschied, dass die Source-Diffusion 4 nicht mehr mit der Kontakt-Diffusion 3 und der Speisespannung V_{SS} verbunden ist, sondern über eine eigene Metallisierung an der Speisespannung V_{S} liegt.

Die in der Fig. 6 dargestellte Schaltung ist ähnlich aufgebaut wie die in der Fig. 2 dargestellte Schaltung, mit dem Unterschied, dass nicht die FET-Transistoren T_{P} der drei Inverter 11 bis 13 sowie der FET-Transistor T_{N} des Inverters 11 je eine Halbleiter-Wanne 2 bzw. 14 aufweisen, sondern die FET-Transistoren T_{N} der drei Inverter 11 bis 13 und der FET-Transistor T_{P} des Inverters 12 je eine Halbleiter-Wanne 2 bzw. 14 besitzen. Das Bulk-Material B der FET-Transistoren T_{P} der Inverter 11 und 13 liegt wieder an der Speisespannung V_{DD}, dasjenige des FET-Transistors T_{N} des Inverters 11 und des FET-Transistors T_{P} des Inverters 12 wieder an der Speisespannung V_{S} und dasjenige der FET-Transistoren T_{N} der Inverter 12 und 13 wieder an der Speisespannung V_{SS}. Liegt nun die Halbleiterschicht 1 an der höchsten in der integrierten Schaltung vorhandenen Speisespannung V_{DD}, was in den Figuren 6 bis 9 angenommen wird, so wird diesmal die am Bulk-Material B des FET-Transistors T_{P} des Inverters 12 liegende Speisespannung V_{S} durch die Halbleiterschicht 1 mit der an der letzteren liegenden Speisespannung V_{DD} kurzgeschlossen.

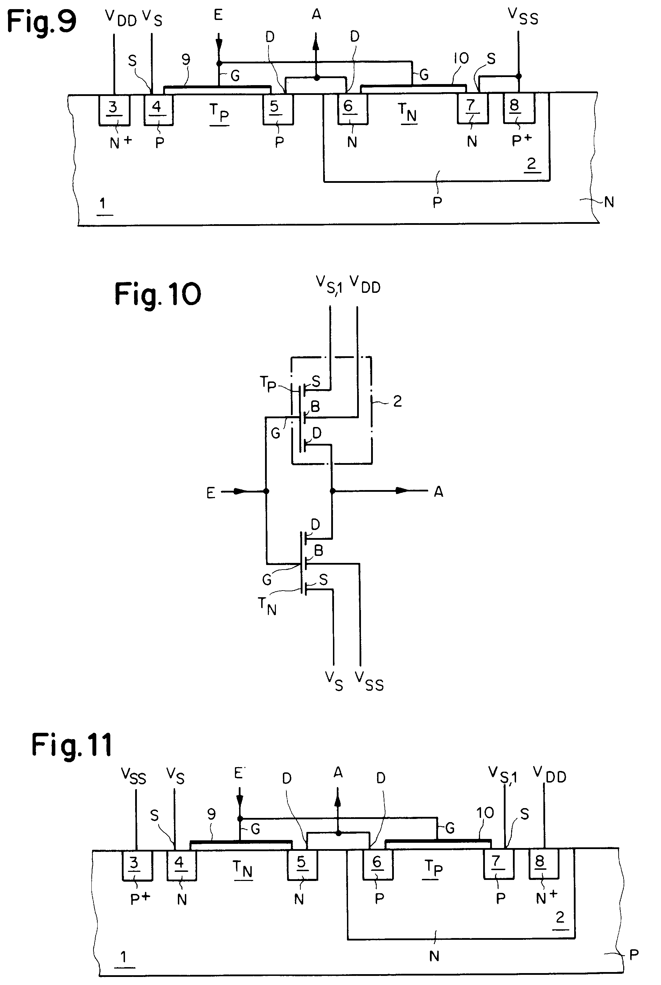

Es ist bekannt, dass auch dieser Kurzschluss vermieden werden kann, wenn der FET-Transistor T_{P} des Inverters 12 an der Oberfläche in einer zusätzlichen Halbleiter-Wanne 14 angeordnet ist, was in der Fig. 6 symbolisch durch die gestrichelte Umrahmung 14 des betreffenden FET-Transistors T_{P} dargestellt ist. Der Inverter 12 besitzt dann den in der Fig. 7 dargestellten Aufbau, der ähnlich ist wie der in der Fig. 3 dargestellte Aufbau, mit dem Unterschied, dass das Halbleitermaterial der Halbleiterschicht 1, der Halbleiter-Wannen 2 und 14 sowie der Diffusionen 3 bis 8 und 15 jeweils vom umgekehrten Leitfähigkeitstyp ist als in der Fig. 3 und dadurch auch der Kanaltyp N und P der beiden FET-Transistoren vertauscht ist, so dass diesmal der FET-Transistor T_{P} in der Halbleiter-Wanne 14 und der FET-Transistor T_{N} in der Halbleiter-Wanne 2 eindiffundiert ist. Ausserdem liegen diesmal die miteinander verbundenen Diffusionen 7 und 8 nicht an der Speisespannung V_{DD}, sondern an der Speisespannung V_{SS}, während die Kontakt-Diffusion 3 nicht an der Speisespannung V_{SS}, sondern an der Speisespannung V_{DD} liegt. Ansonsten ist der in der Fig. 7 dargestellte Aufbau gleich wie der in der Fig. 3 dargestellte Aufbau. Da diesmal der FET-Transistor T_{P} des Inverters 12 durch zwei Sperrschichten von der Halbleiterschicht 1 isoliert ist, wird die Speisespannung V_{S} seines Bulk-Materials B, welches mit dem Halbleitermaterial der Halbleiter-Wanne 14 identisch ist, nicht mehr durch die Halbleiterschicht 1 mit der Speisespannung V_{DD} kurzgeschlossen. Das Vorhandensein der zusätzlichen Halbleiter-Wanne 14 hat dabei in der in den Figuren 6 und 7 dargestellten Schaltungsvariante die gleichen Nachteile wie in der in den Figuren 2 und 3 dargestellten Schaltungsvariante. Um diese zu vermeiden, verwendet eine in den Figuren 8 und 9 dargestellte zweite Variante der erfindungsgemässen Lösung diesmal des Inverters 12 keine Halbleiter-Wanne 14 mehr. Die in der Fig. 8 dargestellte Schaltung ist ähnlich aufgebaut wie die in der Fig. 6 dargestellte Schaltung mit dem Unterschied, dass die Halbleiter-Wanne 14 nicht mehr vorhanden ist und der elektrische Anschluss des Bulk-Materials B des FET-Transistors T_{P} des Inverters 12 nicht mehr mit dem Source-Anschluss S und mit der Speisespannung V_{S} verbunden ist, sondern über eine eigene Metallisierung an der höchsten in der integrierten Schaltung vorhandenen Speisespannung V_{DD} liegt. Da das betreffende Bulk-Material B nun das gleiche Potential V_{DD} besitzt wie die Halbleiterschicht 1, kann der zugehörige FET-Transistor T_{P} des Inverters 12 genau wie die FET-Transistoren T_{P} der Inverter 11 und 13 unmittelbar in die Halbleiterschicht 1 eindiffundiert werden, ohne dass ein Kurzschluss entsteht, obwohl der Source-Anschluss S des betreffenden FET-Transistors T_{P} des Inverters 12 weiterhin an der Speisespannung V_{S} liegt. Der Aufbau des erfindungsgemäss so gespeisten Inverters 12 ist in der Fig. 9 dargestellt. Dieser Aufbau ist ähnlich wie der in der Fig. 5 dargestellte Aufbau, mit dem Unterschied, dass das Halbleitermaterial der Halbleiterschicht 1, der Halbleiter-Wanne 2 sowie der Diffusionen 3 bis 8 jeweils vom umgekehrten Leitfähigkeitstyp ist als in der Fig. 5 und dadurch auch der Kanaltyp N und P der beiden FET-Transistoren vertauscht ist, so dass diesmal der FET-Transistor T_{N} in der Halbleiter-Wanne 2 eindiffundiert ist. Ausserdem liegen diesmal die miteinander verbundenen Diffusionen 7 und 8 nicht an der Speisespannung V_{DD}, sondern an der Speisespannung V_{SS}, während die Kontakt-Diffusion 3 nicht an der Speisespannung V_{SS}, sondern an der Speisespannung V_{DD} liegt. Ansonsten ist der in der Fig. 9 dargestellte Aufbau gleich wie der in der Fig. 5 dargestellte Aufbau.

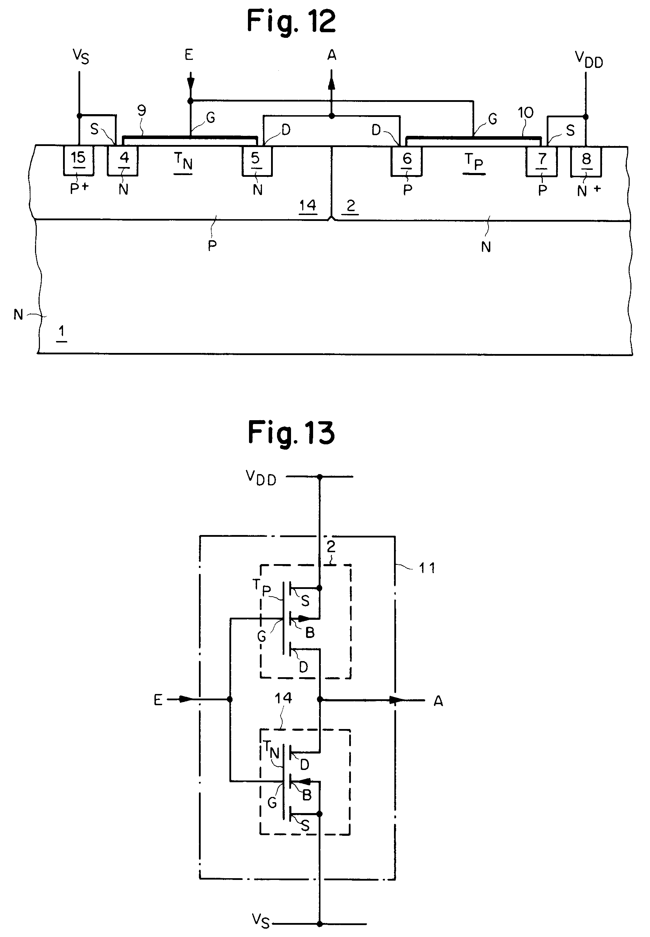

In den beiden bisher beschriebenen erfindungsgemässen Lösungs-Varianten ist entweder im FET-Transistor T_{N} oder im FET-Transistor T_{P} die Verbindung zwischen Bulk-Material B und Source-Anschluss S unterbrochen, um das Bulk-Material B und den Source-Anschluss S an zwei unterschiedlichen Speisespannungen zu legen, so dass der zugehörige Inverter total von drei unterschiedlichen Speisespannungen V_{DD}, V_{SS} und V_{S} gespeist ist. Eine universellere, dritte Lösungs-Variante wird verwirklicht, wenn, wie in den Figuren 10 und 11 dargestellt, sowohl im FET-Transistor T_{N} als auch im FET-Transistor T_{P} die betreffende Verbindung unterbrochen ist, um das Bulk-Material B und den Source-Anschluss S beider FET-Transistoren T_{N} und T_{P} jeweils an zwei unterschiedliche Speisespannungen zu legen, so dass der zugehörige Inverter total von vier verschiedenen Speisespannungen V_{DD}, V_{SS}, V_{S} und V_{S,1} gespeist ist, wobei eine der beiden letzteren Speisespannungen V_{S} oder V_{S,1}, deren Spannungswerte jeweils beide zwischen den Werten von V_{DD} und V_{SS} liegen, z. B. gleich 0 Volt ist. In allen Varianten sind die Speisespannungen V_{S} und V_{S,1} im Absolutwert kleiner als der Absolutwert der elektrischen Speisespannungen V_{SS} und/oder V_{DD}. Zwei der vier Speisespannungen dienen der normalen Speisung des Inverters, während mindestens eine der beiden verbleibenden Speisespannungen wieder zur Verhinderung des erwähnten Kurzschlusses dient.

In der Fig. 10 ist das elektrische Schaltbild eines auf dieser Art gespeisten, in CMOS-Technologie aufgebauten Inverters dargestellt, welches ähnlich ist wie dasjenige des Inverters 13 (siehe Fig. 2), mit dem Unterschied, dass der Source-Anschluss S des FET-Transistors T_{N} an der Speisespannung V_{S} und der Source-Anschluss S des FET-Transistors T_{P} an der Speisespannung V_{S,1} liegt. Mittels der Bulk-Speisespannungen V_{DD} und/oder V_{SS} können gegebenenfalls die Kanal-Tiefe des zugehörigen FET-Transistors T_{P} bzw. T_{N} eingestellt werden. Ausserdem kann im Betrieb durch die Änderung des Wertes einer dieser Bulk-Speisespannungen V_{DD} oder V_{SS} der Schaltzustand des zugehörigen FET-Transistors T_{P} bzw. T_{N} geändert werden. Wenn der letztere dabei ein Teil einer Speicherzelle einer Speicher-Schaltung ist, wird dadurch deren binärer Speicherinhalt geändert, d. h. gesetzt oder gelöscht.

Der halbleitermässige Aufbau des in der Fig. 10 dargestellten Inverters ist in der Fig. 11 dargestellt und ähnlich wie der in der Fig. 5 dargestellte Aufbau, mit dem Unterschied, dass die Source-Diffusion 7 nicht an der Speisespannung V_{DD} liegt und auch nicht mit der Kontakt-Diffusion 8 verbunden ist, sondern über eine eigene Metallisierung an der Speisespannung V_{S,1} liegt.

Die Erfindung ist anhand von CMOS-Schaltungen erläutert worden. Es gilt jedoch als wohlverstanden, dass die Erfindung auch für PMOS- und/oder NMOS-Schaltungen gilt, die alle in einer einzigen gleichen integrierten Schaltung integriert sind, wenn diese PMOS-und/oder NMOS-Schaltungen in mehreren Subschaltungen unterteilt sind, die z. B. von unterschiedlichen Speisespannungen gespeist werden. In diesem Fall ist z. B. die Halbleiter-Wanne 2 die gemeinsame Halbleiterschicht, in denen die FET-Transistoren T_{P} der PMOS-Schaltung unmittelbar eindiffundiert sind, während die FET-Transistoren T_{N} der NMOS-Schaltung unmittelbar in die gemeinsame Halbleiterschicht 1 eindiffundiert sind. Die FET-Transistoren T_{P} der PMOS-Schaltung sind dann vorzugsweise so von den Speisespannungen V_{DD} und V_{S,1} gespeist wie der in der Fig. 10 dargestellte FET-Transistor T_{P}. Die FET-Transistoren T_{N} der NMOS-Schaltung sind vorzugsweise so von den Speisespannungen V_{SS} und V_{S} gespeist wie der in der Fig. 10 dargestellte FET-Transistor T_{N}.

In den in den Figuren 3 und 7 dargestellten bekannten CMOS-Inverter-Halbleiteranordnungen ist die Halbleiter-Wanne 14 jeweils an der Oberfläche in die Halbleiter-Wanne 2 eindiffundiert. Es ist jedoch bekannt, dass die beiden Halbleiter-Wannen 2 und 14 in diesen Fällen auch nebeneinander an der Oberfläche in der Halbleiterschicht 1 angeordnet sein können. Dies ist in der Fig. 12 für den Fall der in der Fig. 3 dargestellten CMOS-Inverter-Halbleiteranordnung dargestellt, wobei klar ist, dass für die in der Fig. 7 dargestellte CMOS-Inverter-Halbleiteranordnung ein ähnlicher Aufbau möglich ist, der sich hauptsächlich von dem in der Fig. 12 dargestellten Aufbau nur dadurch unterscheidet, dass die verschiedenen Leitfähigkeitstypen N und P der Halbleitermaterialien vertauscht sind. Zu dem in der Fig. 12 dargestellten Querschnitt gehört das in der Fig. 13 dargestellte Schaltbild. Die Fig. 12 ist ähnlich der Fig. 3 mit dem Unterschied, dass die Halbleiter-Wanne 14 nicht in die Halbleiter-Wanne 2, sondern neben der letzteren an der Oberfläche unmittelbar in die Halbleiterschicht 1 eindiffundiert ist, welche in diesem Fall z. B. vom Leitfähigkeitstyp N ist. Die Kontakt-Diffusion 3 mit ihrem Anschluss wurden aus Gründen der zeichnerischen Einfachheit in der Fig. 12 weggelassen. Das in der Fig. 13 dargestellte Schaltbild ist ähnlich wie dasjenige des in der Fig. 2 dargestellten CMOS-Inverters 11, mit dem Unterschied, dass die den FET-Transistor T_{N} enthaltende Halbleiter-Wanne 14 nicht in die Halbleiter-Wanne 2, sondern unmittelbar in die Halbleiterschicht 1 eindiffundiert ist.

In den beiden ersten erfindungsgemässen Varianten der integrierten Schaltung, welche Feldeffekt-Transistoren gleichen oder unterschiedlichen Kanaltyps N und/oder P enthält, liegt somit ein Source-Anschluss S mindestens eines ersten Feldeffekt-Transistors T_{N} von 11 oder T_{P} von 12, dessen Kanal aus Halbleitermaterial eines bestimmten Leitfähigkeitstyps N bzw. P besteht, an einer ersten Speisespannung V_{S}. Ein Anschluss B eines Bulk-Materials des gleichen Leitfähigkeitstyps N bzw. P mindestens eines weiteren Halbleiter-Bauelementes liegt an einer unterschiedlichen zweiten Speisespannung V_{SS} bzw. V_{DD}, wobei das Bulk-Material des weiteren Halbleiter-Bauelementes aus einer Halbleiterschicht 1 oder 2 besteht. Bis hierher galt die Annahme, dass das weitere Halbleiter-Bauelement ein zweiter Feldeffekt-Transistor T_{N} bzw. T_{P} von 13 ist, der in die Halbleiterschicht 1 bzw. 2 eindiffundiert ist und dessen Source-Anschluss S an der zweiten Speisespannung V_{SS} bzw. V_{DD} liegt. In allen drei erfindungsgemässen Varianten kann es jedoch auch ein anderes Halbleiter-Bauelement sein, z. B. eine Diode. Der erste Feldeffekt-Transistor T_{N} von 11 bzw. T_{P} von 12 ist unmittelbar in der Halbleiterschicht 1 bzw. 2 eindiffundiert, so dass deren Halbleitermaterial auch das Bulk-Material des ersten Feldeffekt-Transistors T_{N} von 11 bzw. T_{P} von 12 bildet. Ein Anschluss B des Bulk-Materials des ersten Feldeffekt-Transistors T_{N} von 11 bzw. T_{P} von 12 liegt zwecks gegenseitiger elektrischer Isolation des letzteren und des weiteren Halbleiter-Bauelementes T_{N} bzw. T_{P} von 13 an der zweiten Speisespannung V_{SS} bzw. V_{DD}.

In der dritten erfindungsgemässen Variante sind Feldeffekt-Transistoren T_{N} und T_{P} unterschiedlichen Kanaltyps N und P vorhanden. Dabei liegt jeweils pro vorhandenem Kanaltyp N und P der Source-Anschluss S mindestens eines ersten Feldeffekt-Transistors T_{N} bzw. T_{P} des betreffenden Kanaltyps N bzw. P an einer ersten Speisespannung V_{S} oder V_{S,1}, während ein Anschluss B eines Bulk-Materials des gleichen Leitfähigkeitstyps N bzw. P mindestens eines weiteren Halbleiter-Bauelementes, z. B. eines zweiten Feldeffekt-Transistors oder einer Diode, jeweils an der unterschiedlichen zweiten Speisespannung V_{SS} bzw. V_{DD} liegt. Dabei besteht das Bulk-Material des weiteren Halbleiter-Bauelementes jeweils aus einer Halbleiterschicht 1 bzw. 2, in der der betreffende erste Feldeffekt-Transistor T_{N} von 11 bzw. T_{P} von 12 unmittelbar eindiffundiert ist, so dass deren Halbleitermaterial jeweils auch das Bulk-Material des ersten Feldeffekt-Transistors T_{N} von 11 bzw. T_{P} von 12 des betreffenden Kanaltyps N bzw. P bildet. Für jeden vorhandenen Kanaltyp N und P liegt jeweils ein Anschluss B des Bulk-Materials des zugehörigen ersten Feldeffekt-Transistors T_{N} von 11 bzw. T_{P} von 12 zwecks gegenseitiger elektrischer Isolation des letzteren und des zugehörigen weiteren Halbleiter-Bauelementes an der zweiten Speisespannung V_{SS} bzw. V_{DD}.

Der Absolutwert der zweiten Speisespannung V_{SS} bzw. V_{DD} ist in allen Varianten vorzugsweise grösser als der Absolutwert der ersten Speisespannung V_{S} bzw. V_{S,1}.

Die Feldeffekt-Transistoren T_{N} und T_{P} unterschiedlichen Kanaltyps N und P sind Teil einer CMOS-Schaltung oder jeweils Teil einer NMOS- beziehungsweise PMOS-Schaltung. Im letzteren Fall sind in der integrierten Schaltung vorzugsweise mindestens eine NMOS- und mindestens eine PMOS-Schaltung vorhanden.

## Patentansprüche

1. Integrierte Schaltung mit Feldeffekt-Transistoren gleichen oder unterschiedlichen Kanaltyps (N und/oder P), in der
- ein Source-Anschluss (S) mindestens eines ersten Feldeffekt-Transistors (T_{N} von 11 oder T_{P} von 12), dessen Kanal aus Halbleitermaterial eines bestimmten Leitfähigkeitstyps (N oder P) besteht, an einer ersten Speisespannung (V_{S}) und
- ein Anschluss (B) eines Bulk-Materials des gleichen Leitfähigkeitstyps (N bzw. P) mindestens eines weiteren Halbleiter-Bauelementes (T_{N} bzw. T_{P} von 13) an einer unterschiedlichen zweiten Speisespannung (V_{SS} bzw. V_{DD}) liegt,
- wobei das Bulk-Material des weiteren Halbleiter-Bauelementes (T_{N} bzw. T_{P} von 13) aus einer Halbleiterschicht (1 oder 2) besteht,
dadurch gekennzeichnet,
- dass der erste Feldeffekt-Transistor (T_{N} von 11 bzw. T_{P} von 12) unmittelbar in der Halbleiterschicht (1 bzw. 2) eindiffundiert ist,
- so dass deren Halbleitermaterial auch das Bulk-Material des ersten Feldeffekt-Transistors (T_{N} von 11 bzw. T_{P} von 12) bildet, und
- dass ein Anschluss (B) des Bulk-Materials des ersten Feldeffekt-Transistors (T_{N} von 11 bzw. T_{P} von 12) zwecks gegenseitiger elektrischer Isolation des letzteren und des weiteren Halbleiter-Bauelementes (T_{N} bzw. T_{P} von 13) an der zweiten Speisespannung (V_{SS} bzw. V_{DD}) liegt.

2. Integrierte Schaltung nach Anspruch 1, dadurch gekennzeichnet,
- dass Feldeffekt-Transistoren (T_{N} und T_{P}) unterschiedlichen Kanaltyps (N und P) vorhanden sind,
- dass pro vorhandenem Kanaltyp (N und P) der Source-Anschluss (S) mindestens eines ersten Feldeffekt-Transistors (T_{N} bzw. T_{P}) des betreffenden Kanaltyps (N bzw. P) jeweils an der ersten Speisespannung (V_{S} oder V_{S,1}) und
- ein Anschluss (B) eines Bulk-Materials des gleichen Leitfähigkeitstyps (N bzw. P) mindestens eines weiteren Halbleiter-Bauelementes (T_{N} bzw. T_{P} von 13) jeweils an der unterschiedlichen zweiten Speisespannung (V_{SS} bzw. V_{DD}) liegt,
- wobei das Bulk-Material des weiteren Halbleiter-Bauelementes (T_{N} bzw. T_{P} von 13) jeweils aus einer Halbleiterschicht (1 bzw. 2) besteht,
- in der der betreffende erste Feldeffekt-Transistor (T_{N} von 11 bzw. T_{P} von 12) unmittelbar eindiffundiert ist,
- so dass deren Halbleitermaterial jeweils auch das Bulk-Material des ersten Feldeffekt-Transistors (T_{N} von 11 bzw. T_{P} von 12) des betreffenden Kanaltyps (N bzw. P) bildet, und
- dass für jeden vorhandenen Kanaltyp (N und P) jeweils ein Anschluss (B) des Bulk-Materials des zugehörigen ersten Feldeffekt-Transistors (T_{N} von 11 bzw. T_{P} von 12) zwecks gegenseitiger elektrischer Isolation des letzteren und des zugehörigen weiteren Halbleiter-Bauelementes (T_{N} bzw. T_{P} von 13) an der zweiten Speisespannung (V_{SS} bzw. V_{DD}) liegt.

3. Integrierte Schaltung nach Anspruch 1 oder 2, dadurch gekennzeichnet, dass das weitere Halbleiter-Bauelelement (T_{N} bzw. T_{P} von 13) ein zweiter Feldeffekt-Transistor ist, der in die Halbleiterschicht (1 bzw. 2) eindiffundiert ist und dessen Source-Anschluss (S) an der zweiten Speisespannung (V_{SS} bzw. V_{DD}) liegt.

4. Integrierte Schaltung nach einem der Ansprüche 1 bis 3, dadurch gekennzeichnet, dass der Absolutwert der zweiten Speisespannung (V_{SS} bzw. V_{DD}) grösser ist als der Absolutwert der ersten Speisespannung (V_{S}, V_{S,1}).

5. Integrierte Schaltung nach einem der Ansprüche 1 bis 4, dadurch gekennzeichnet, dass die Feldeffekt-Transistoren (T_{N} und T_{P}) unterschiedlichen Kanaltyps (N und P) teil einer CMOS-Schaltung sind.

6. Integrierte Schaltung nach einem der Ansprüche 1 bis 4, dadurch gekennzeichnet, dass die Feldeffekt-Transistoren (T_{N} und T_{P}) unterschiedlichen Kanaltyps (N und P) jeweils Teil einer NMOS- beziehungsweise PMOS-Schaltung sind.

7. Integrierte Schaltung nach Anspruch 6, dadurch gekennzeichnet, dass in der integrierten Schaltung mindestens eine NMOS- und mindestens eine PMOS-Schaltung vorhanden sind.
